Europäisches Patentamt

European Patent Office

Office européen des brevets

(19)

(11) Publication number: **0 387 792**
**A1**

# EUROPEAN PATENT APPLICATION

(12)

(21) Application number: **90104728.2**

(22) Date of filing: **13.03.90**

(51) Int. Cl.5: **H03K 19/0175, H03K 19/08**

(30) Priority: **13.03.89 JP 57834/89**

(43) Date of publication of application:
**19.09.90 Bulletin 90/38**

(84) Designated Contracting States:
**DE FR GB**

(71) Applicant: **Kabushiki Kaisha Toshiba**
**72, Horikawa-cho Saiwai-ku**
**Kawasaki-shi(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Matsuo, Kenji, c/o Intellectual**
**Property Div.**
**K.K. Toshiba, 1-1 Shibaura 1-chome,**
**Minato-ku**
**Tokyo 105(JP)**

Inventor: **Tsuchiya, Ikuo, c/o Intellectual**
**Property Div.**
**K.K. Toshiba, 1-1 Shibaura 1-chome,**
**Minato-ku**
**Tokyo 105(JP)**
Inventor: **Kimura, Masahiro, c/o Intellectual**
**Property Div.**
**K.K. Toshiba, 1-1 Shibaura 1-chome,**
**Minato-ku**
**Tokyo 105(JP)**
Inventor: **Ookawauchi, Tadahisa, c/o Int.**
**Property Div.**
**K.K. Toshiba, 1-1 Shibaura 1-chome,**
**Minato-ku**
**Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Output buffer circuit.**

(57) An output buffer circuit includes an input node (1), an output node (2), a positive power source ($V_{DD}$), a logic circuit (10) connected to the input node (1), means (11) connected at one end to the logic circuit (10), for dropping a voltage of the logic circuit (10), and a bipolar transistor (12) having a base connected to the other end of the voltage dropping means (11) and the other end of the logic circuit (10), a collector connected to the output node (2) and an emitter connected to a circuit ground (GND).

FIG. 1

EP 0 387 792 A1

## Output buffer circuit

This invention relates to an output buffer circuit, and more particularly to a Bi-CMOS output buffer circuit.

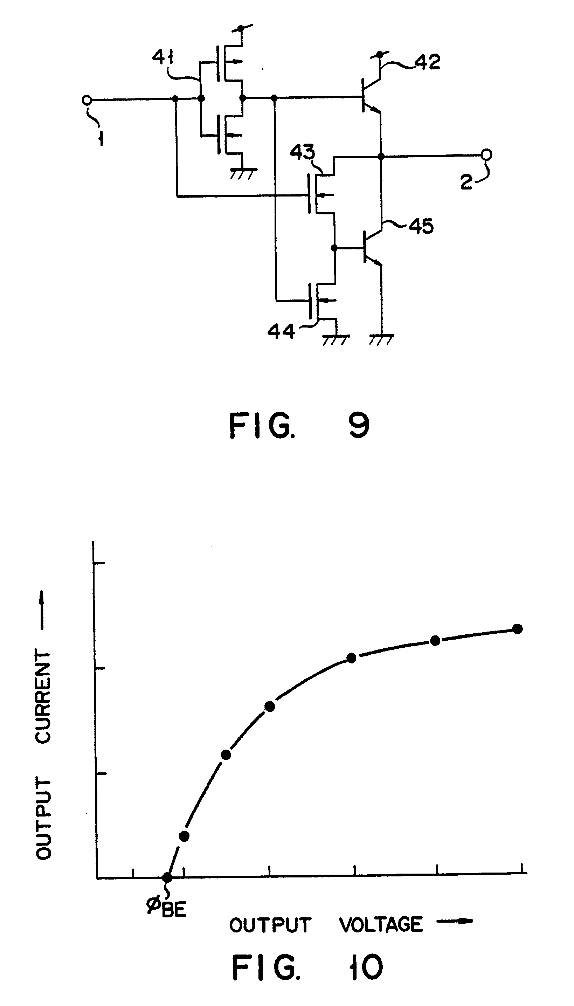

First, a conventional output buffer circuit is explained with reference to Figs. 9 and 10. Fig. 9 is a circuit diagram of the conventional Bi-CMOS output buffer circuit.

The conventional Bi-CMOS output buffer circuit includes a CMOS inverter circuit 41 connected to an input terminal 1, a bipolar transistor 42 having a base connected to the output terminal of the CMOS inverter circuit 41, an N-channel transistor 43 having a drain connected to the emitter of the bipolar transistor 42 and a gate connected to the input terminal 1, an N-channel transistor 44 having a drain connected to the source of the N-channel transistor 43 and a gate connected to the output terminal of the CMOS inverter circuit 41, and a bipolar transistor 45 having a base connected to the drain of the N-channel transistor 44.

With the above construction, when a voltage of high level ("H" level) is applied to the input terminal 1, the output of the CMOS inverter 41 is inverted to a low level ("L" level), and the bipolar transistor 42 is turned off. On the other hand, the N-channel transistor 44 is turned off, too. When a voltage of the input terminal 1 is set at the "H" level, the N-channel transistor 43 is turned on, causing a current to start to flow between the drain and the source thereof. Since the current flows as the base current of the bipolar transistor 45, the bipolar transistor 45 is turned on, causing a collector current to flow. When the collector current starts to flow, the voltage at the output terminal 2 which has been held at the "H" level starts to become lower to the "L" level.

Fig. 10 shows the low level current characteristic of the Bi-CMOS output buffer circuit shown in Fig. 9.

With the above Bi-CMOS output buffer circuit, when a "H" level circuit is input to the input terminal 1, the N-channel transistor 43 is turned on, causing a drain current to flow. At this time, since the drain of the N-channel transistor 43 is connected to the output terminal 2 and the source of the N-channel transistor 43 is connected to the base of the bipolar transistor 45, the output terminal 2 and the base of the bipolar transistor 45 are short-circuited. Further, when the base-emitter voltage (which is hereinafter referred to as "$V_{BE}$") of the bipolar transistor is set to be equal to the built-in potential (which is hereinafter referred to as $\phi_{BE}$) by the drain current, the bipolar transistor is turned on, causing a collector current to flow. Then, a voltage of the output terminal 2 is lowered by the collector current. However, since the output terminal 2 is connected to the base of the bipolar transistor 45 via the N-channel transistor 43, a voltage of the output terminal 2 becomes equal to the base voltage and is set to $V_{BE}$. That is, even when the voltage of the output terminal 2 is lowered, it will not become lower than $\phi_{BE}$, and it is impossible to set the output current while the voltage of the output terminal 2 is lower than $\phi_{BE}$. If the "L" level output voltage of the output terminal 2 is set to be higher than $\phi_{BE}$ and an "L" level input voltage of an ordinary TTL device or a circuit arranged at the succeeding stage is lower than $\phi_{BE}$, it becomes impossible to obtain a direct interface.

An object of this invention is to provide a Bi-CMOS output buffer circuit whose output voltage can be freely set so as to drive a load by an optimum output current.

This invention provides an output buffer circuit comprising an input node (1); an output node (2); a positive power source ($V_{DD}$); a logic circuit (10) connected to the input node (1); dropping voltage means (11) connected at one end to the logic circuit (10); and a bipolar transistor (12) having a base connected to the other end of the dropping means (11) and the other end of the logic circuit (10), a collector connected to the output node (2) and an emitter connected to a circuit ground (GND).

With the above construction, the output buffer circuit is operated as follows. That is, the logic circuit receives a signal of $V_{DD}$ level or 0 level which is input to the input node to connect the positive power source and the dropping means (11) to each other or connect the circuit ground and the base of the bipolar transistor to each other. In other words, a signal of $V_{DD}$ or 0 level is output. As a result, the dropping means drops a voltage from the positive power source to supply an optimum voltage to the base of the bipolar transistor. In this case, since the voltage is set to the optimum level, a voltage applied to the base of the bipolar transistor will cause connect a collector to a base unlike the prior art case and the output current can be prevented from flowing into a collector. Further, the base of the bipolar transistor can be lowered to a potential of 0 level by connecting the base to a ground terminal. In this way, the operation of the bipolar transistor can be effected with high reliability.

As described above, the output buffer circuit will not receive electrical influence from a voltage of the output terminal and it becomes possible to achieve an interface between the output buffer circuit and a load. As a result, even when the voltage of the output terminal is too low (under $\phi_{BE}$), it can drive the load with a stable output current.

EP 0 387 792 A1

This invention can be more fully understood from the following detailed description when taken in conjunction with the accompanying drawings, in which:

Fig. 1 is a block diagram showing an output buffer circuit of this invention;

Fig. 2 is a circuit diagram showing one embodiment of an output buffer circuit of this invention;

Fig. 3 is a graph showing a current characteristic of a P-channel transistor in the output buffer circuit of Fig. 2;

Fig. 4 is a graph showing a current characteristic of the output buffer circuit of Fig. 2;

Fig. 5 is a circuit diagram showing a second embodiment of an output buffer circuit of this invention;

Fig. 6 is a circuit diagram showing a third embodiment of an output buffer circuit of this invention;

Fig. 7 is a circuit diagram showing a fourth embodiment of an output buffer circuit of this invention;

Fig. 8 is a graph showing a current characteristic of the output buffer circuit of Fig. 7;

Fig. 9 is a circuit diagram showing an output buffer circuit to which this invention is not applied;

Fig. 10 is a graph showing a current characteristic of the output buffer circuit of Fig. 9; and

Fig. 11 is a graph showing current characteristics of the output buffer circuit of Fig. 9 and the embodiment of this invention.

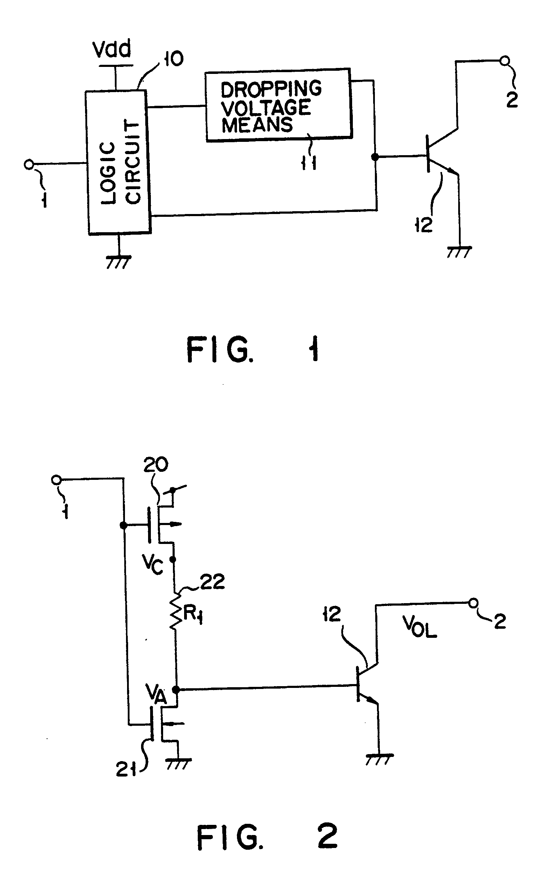

There will now be described an output buffer circuit according to an embodiment of this invention with reference to Figs. 1 to 5.

Fig. 1 is a block diagram showing the construction of an output buffer circuit according to the embodiment of this invention.

The output buffer circuit of this invention includes a logic circuit section 10 connected to power sources of $V_{DD}$ level and 0 level to selectively output a potential of $V_{DD}$ level or 0 level, a voltage dropping unit 11 connected to the output terminal of the logic circuit section 10 to lower the output voltage of the logic circuit section 10 when the output voltage is at the $V_{DD}$ level, and a bipolar transistor 12 having a base connected to the output terminal of the voltage dropping unit 11, an emitter set at a 0 level potential and a collector connected to the output terminal.

In the above example, the bipolar transistor is formed of npn type but it can be formed of pnp type.

When a voltage of $V_{DD}$ level is output from the logic circuit section 10, the voltage is lowered by means of the voltage dropping unit 11 to a voltage $\phi_{BE}$ (0.7 V) which is necessary for turning on the bipolar transistor 12. That is, the base potential of the bipolar transistor 12 is set to $\phi_{BE}$. After this, if the dropped voltage is supplied to the bipolar transistor 12, a collector current starts to flow. The collector current causes the voltage of the output terminal 2 to start to decrease.

Fig. 2 is a circuit diagram showing an output buffer circuit according to a first embodiment of this invention which is constructed based on the block diagram shown in Fig. 1.

The output buffer circuit includes a CMOS inverter constituted by a P-channel transistor 20 and an N-channel transistor 21 whose gates are connected to the input terminal 1 and which are connected between the power source terminals of $V_{DD}$ level and 0 level, a resistor $R_1$ connected between the drains of the P-channel and N-channel transistors 20 and 21, and a bipolar transistor 12 having a base connected to the drain of the N-channel transistor 21, an emitter connected to the ground terminal of 0 level and a collector connected to the output terminal 2. The bipolar transistor 12 may be formed of pnp type.

When a voltage of 0 level is input to the input terminal 1, the N-channel transistor 21 is turned off and the P-channel transistor 20 is turned on. When the P-channel transistor 20 is turned on, a drain current $I_D$ starts to flow. In this case, if the drain potential is $V_C$, then the voltage $V_C$ is lowered to $V_A$ by the resistor $R_1$ 22. The voltage $V_A$ is applied to the base of the bipolar transistor 12, and when the bipolar transistor 23 is turned on, a collector current $I_{OL}$ starts to flow and an output voltage $V_{OL}$ which is a collector voltage is lowered. At this time, since the output terminal 2 is not connected to the base of the bipolar transistor, the output voltage $V_{OL}$ continues to be lowered without receiving any influence by $V_{BE}$ while the bipolar transistor 23 is kept on. That is, the output terminal 2 is connected to the circuit ground terminal and can be set at a potential of 0 level.

Further, the following equation can be obtained based on the characteristic of the bipolar transistor.

$$I_C = I_B \times h_{FE} \quad (1)$$

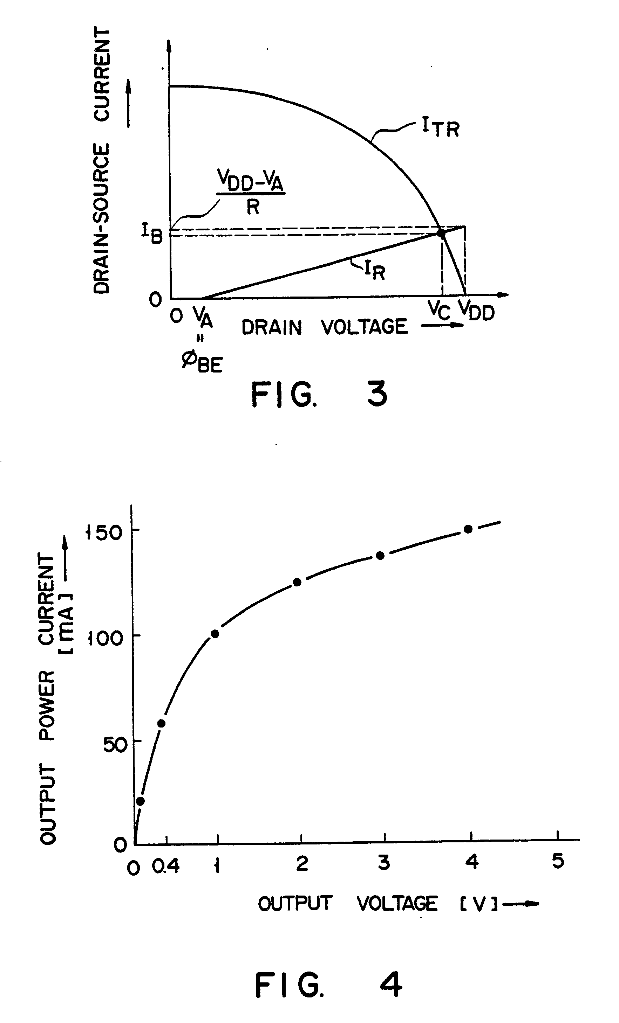

where $I_C$ is a collector current, $I_B$ is a base current and $h_{FE}$ is a current amplification factor. Since, in this circuit, $I_C = I_{OL}$, $I_B$ can be determined based on Eq. (1) if $I_{OL}$ and $h_{FE}$ are previously determined in a case where a desired output current $I_{OL}$ is set. Further, as shown in Fig. 3, intersect beween the characteristic curve of the drain current $I_D$ of the P-channel transistor 20 and a characteristic curve of a current flowing in the resistor $R_1$ as load indicates required $I_B$ and $V_C$. The transistor characteristic curve is determined by the channel width W, channel length L and the like of the transistor and the resistor characteristic curve is determined by the resistance of the resistor. Therefore, a desired output current $I_{OL}$ can be set by selectively setting the channel width, the channel length and the resistance to adequate values.

3

Fig. 4 shows the low level current characteristic of the output buffer circuit of Fig. 1.

In Fig. 4, the abscissa indicates an output voltage and the ordinate indicates an output current. In this case, the element constants are determined such that $R_1$ = 1.7 KΩ, the power source voltage $V_{DD}$ = 5V and W/L = 90/1.5.

As is clearly seen from Fig. 4, the output current $I_{OL}$ flows even when the output voltage $V_{OL}$ is lower than $\phi_{BE}$ (0.7 V) and the operation of the output buffer circuit is correctly effected.

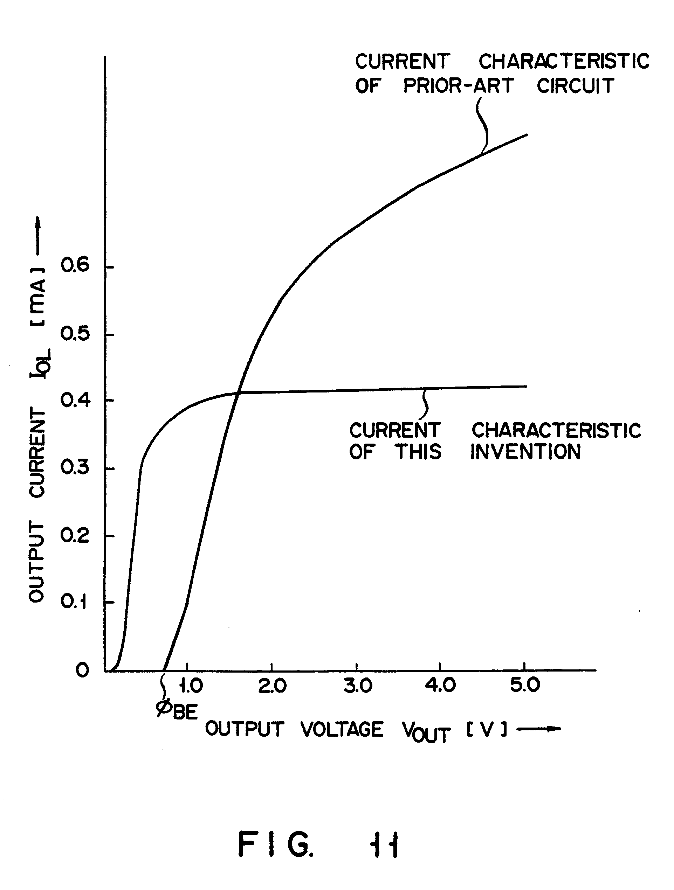

Fig. 11 is a graph showing the output current characteristics of the embodiment of this invention and a circuit of Fig. 9 to which this invention is not applied. According to the graph of Fig. 11, it is understood that the current characteristic of the circuit to which this invention is applied will be able to flow, even if the output voltage is under $\phi_{BE}$. Therefore, it is possible to drive circuit, even if an input voltage of next circuit is under $\phi_{BE}$. In contrast, since the current characteristic of the circuit to which this invention is not applied will not be able to flow, when the voltage of the output node is under $\phi_{BE}$. So, this circuit is not capable of driving directly under $\phi_{BE}$.

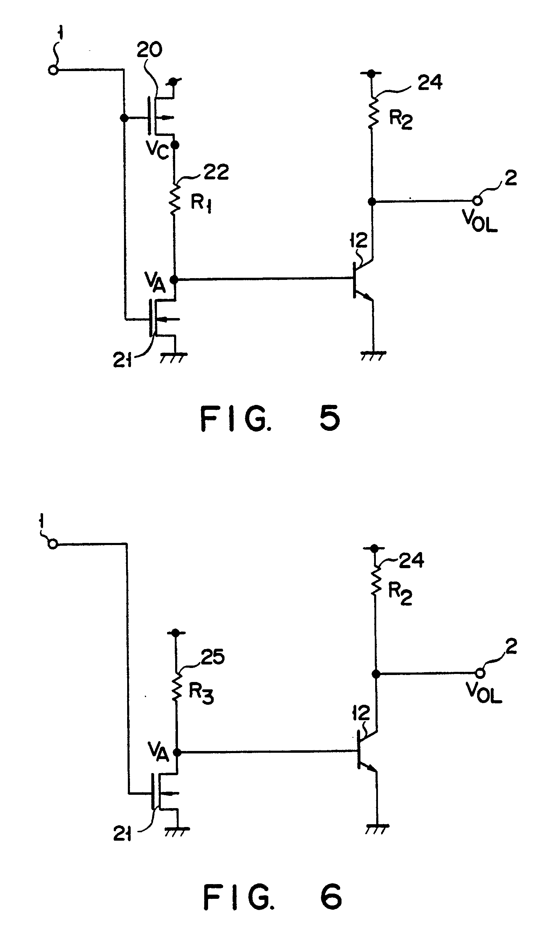

Fig. 5 is a circuit diagram showing an output buffer circuit according to a second embodiment of this invention. The reference numerals shown in Fig. 5 are the same as those used in Fig. 2.

This output buffer circuit is obtained by additionally connecting a pull-up resistor $R_2$ 24 between the power source and the output terminal of the output buffer circuit shown in Fig. 2. Therefore, it becomes possible to directly drive the load without supplying an output voltage from the exterior.

When a voltage of "H" level is applied to the input terminal 1, the P-channel transistor 20 is turned off and the N-channel transistor 21 is turned on. When the N-channel transistor 21 is turned on, a drain current $I_D$ starts to flow, thereby causing the base voltage of the bipolar transistor 23 to be gradually lowered. When the base potential becomes lower than $\phi_{BE}$ ($V_{BE} < \phi_{BE}$), the bipolar transistor 12 is turned off. At this time, a voltage of $V_{DD}$ level is output from the output terminal 2 since one end of the pull-up resistor $R_2$ 24 is connected to the output terminal 2 and the other end of the pull-up resistor $R_2$ 24 is connected to the $V_{DD}$ power source.

With the above output buffer circuit, the pull-up resistor is connected to output terminal 2 so as to permit a voltage of $V_{DD}$ level to be output from the output terminal 2 when a voltage of "H" level is input to the input terminal 1 unlike the first embodiment in which the output terminal 2 is set into the high impedance state.

Fig. 6 is a circuit diagram showing an output buffer circuit according to a third embodiment of this invention. Reference numerals used in Fig. 6 correspond to those used in Fig. 5.

The output buffer circuit can be obtained by replacing the P-channel transistor 20 and the resistor $R_1$ 22 of the output buffer circuit of Fig. 5 by a load resistor $R_3$ 25. In this case, the bipolar transistor 12 can be formed of pnp type.

When a voltage of "L" level is input to an input terminal 1, an N-channel transistor 21 is turned off. At this time, a voltage lower than a voltage of $V_{DD}$ level by the voltage drop across the load resistor $R_3$ is set as the base potential of the bipolar transistor 12 since the base of the bipolar transistor 12 is connected to a $V_{DD}$ power source via the load resistor $R_3$ 25. That is, the base current can be set to a desired value by changing the resistance of the load resistor $R_3$ 25. Concretely speaking, the following equation can be obtained.

$$I_B = \frac{V_{DD} - V_{BE}}{R} \qquad\qquad --- (2)$$

Then, the following equation can be obtained by substituting Eq. (1) into Eq. (2).

$$R = \frac{I_{OL}}{h_{FE}} (V_{DD} - V_{BE}) \qquad\qquad --- (3)$$

In this case, if $h_{FE}$ = 50, $V_{DD}$ = 5 V, $V_{BE}$ = $\phi_{BE}$ = 0.7 V and $I_{OL}$ = 40 mA, then R = 5.375 KΩ can be obtained. If $V_{BE}$ is higher than $\phi_{BE}$, the bipolar transistor 12 is turned on and a collector current starts to flow, thereby lowering the voltage of the output terminal 2.

When a voltage of "H" level is input to the input terminal 1, the same operation as in the case of the second embodiment may be effected.

With the above output buffer circuit, the same effect as obtained in the second embodiment can be attained with the reduced number of elements.

4

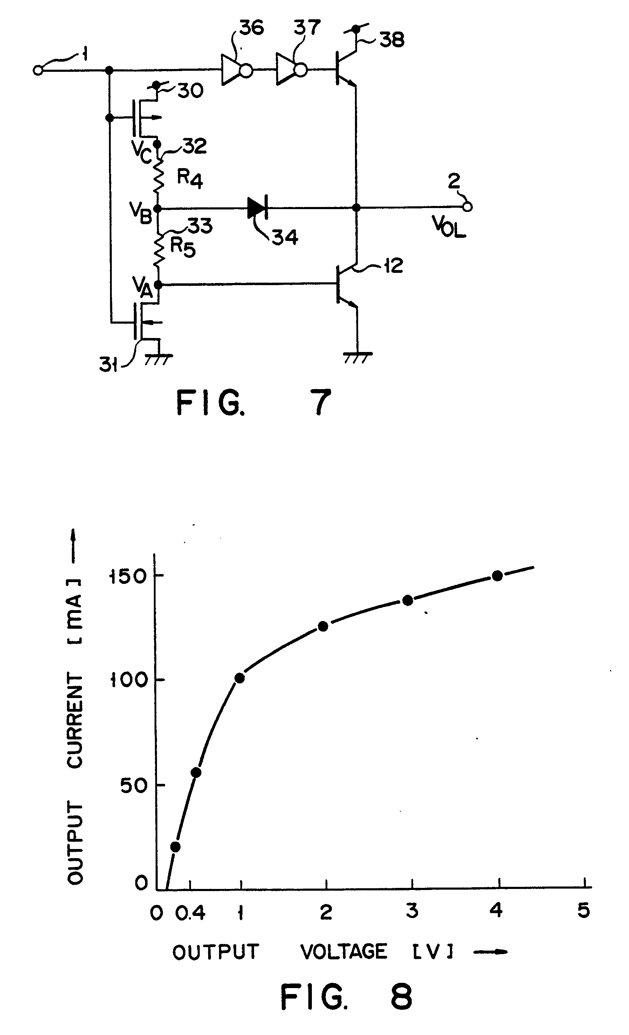

Fig. 7 is a circuit diagram showing an output buffer circuit according to a fourth embodiment of this invention.

The output buffer circuit includes a CMOS inverter constituted by P-channel and N-channel transistors 30 and 31 whose gates are connected to an input terminal 1 and which are connected between the power sources of $V_{DD}$ level and 0 level, two resistors $R_4$ 32 and $R_5$ 33 series-connected between the drains of the P-channel transistor 30 and N-channel transistor 31, a diode 34 having an anode connected to a connection node between the resistors $R_4$ 32 and $R_5$ 33 and a cathode connected to an output terminal 2, a bipolar transistor 12 having a base connected to the drain of the N-channel transistor 31, an emitter connected to a ground terminal of 0 level and a collector connected to the output terminal 2, 2-stage inverters 36 and 37 cascade-connected to the input terminal 1, and a bipolar transistor 38 having a base connected to the output terminal of the inverter 37, a collector connected to a power source of $V_{DD}$ level and an emitter connected to output terminal 2.

When a voltage of "H" level is input to the input terminal, the P-channel transistor 30 is turned off and the N-channel transistor 31 is turned on. When the N-channel transistor 31 is turned on, a drain current starts to flow, thereby lowering the base voltage of the bipolar transistor 12 to turn off the bipolar transistor 12. The voltage of "H" level at the input terminal is input to the base of the bipolar transistor 38 without changing the level thereof by means of the 2-stage inverters 36 and 37. When a voltage of "H" level is input to the base and $V_{BE}$ becomes higher than $\phi_{BE}$, the bipolar transistor 38 is turned on and a collector current (emitter current) starts to flow. When the collector current (emitter current) flows, a voltage lower than the $V_{DD}$ level by $\phi_{BE}$ is output from the output terminal 2.

When a voltage of "L" level is input to the input terminal 1, the input voltage is input to the base of the bipolar transistor 38 without changing the level thereof by means of the 2-stage inverters 36 and 37 so as to turn off the bipolar transistor 38. Further, application of the voltage to the input terminal 1 causes the P-channel and N-channel transistors 30 and 31 to be turned on and off, respectively. When the P-channel transistor 30 is turned on, a drain current $I_D$ starts to flow. Assuming now that the drain potential of the P-channel transistor 30 is $V_C$, the voltage $V_C$ is lowered to $V_B$ by means of the resistor $R_4$ 32. The voltage $V_B$ is further lowered to $V_A$ by means of the resistor $R_5$ 33. The voltage $V_A$ is applied to the base of the bipolar transistor 12, and a collector current starts to flow and the output voltage $V_{OL}$ is gradually lowered after the bipolar transistor 12 is turned on. At this time, since the output terminal and the base are not short-circuited, the output voltage $V_{OL}$ continues to decrease without receiving any influence by $V_{BE}$ while the bipolar transistor 12 is kept in the conductive state. That is, the output voltage $V_{OL}$ lower than $\phi U_{BE}$ (0.7 V) can be obtained.

The diode 34 of the output buffer circuit is used as a current clamping element for suppressing the switching noise. When a voltage on the output terminal changes from 0 V to $V_{DD}$ or from $V_{DD}$ to 0 V, noise called ringing is generated. The diode 34 functions in the following manner to suppress the noise. When the output voltage is lowered to a certain level and a potential difference across the diode 34 is set to a voltage level $\phi U'_{BE}$ which is necessary for turning on the diode 34, a current starts to flow in the diode and the base current of the bipolar transistor 12 is reduced. In this way, the output current becomes smaller as the base current is reduced, and the output current becomes 0 before the output voltage becomes 0. This is also understood from the current characteristic shown in Fig. 8. In this case, the element constants are determined such that W/L = 90/1.5, $V_{DD}$ = 5 V, $R_4$ = 1.6 KΩ and $R_5$ = 100 Ω. As described above, when the output voltage is lowered to a certain level, the output current rapidly decreases, and when the output voltage is near 0, the output current is set to 0 so that the rate of variation in the current may become low and noise can be suppressed.

The rising portion of the current characteristic of the Schottky diode is steeper as compared with that of the above diode, and it is possible to attain the better effect by replacing the diode by the Schottky diode.

The 2-stage inverters 36 and 37 are used as an amplifier for preventing the voltage level-down which may occur when the voltage of the input terminal 1 is applied to another circuit.

Further, a method for setting the output current is effected in the same manner as in the first embodiment.

With the above output buffer circuit, the same effect as in the second embodiment can be obtained, and an additional effect of low power consumption can be attained since an "H" level voltage is output by means of the bipolar transistor 38 instead of the pull-up resistor $R_2$ 24 and a through current can be interrupted. Further, since the diode 34 is provided, an output buffer circuit which is highly resistant to switching noise can be obtained.

In this embodiment, the N-channel transistor 31 is used to lower the base voltage of the bipolar transistor 12, but the same effect can be attained by replacing the same by a resistor.

As described above, according to this invention, an output voltage of the logic circuit section can be lowered to a desired voltage level by use of the voltage dropping unit so that an adequate base voltage can be supplied and a reverse current in the bipolar transistor can be prevented. Further, in this output buffer circuit, $V_{BE}$ of the bipolar transistor is set independently from the voltage of the output terminal 2 so that the level of the voltage of the output terminal 2 can be set in under $\phi_{BE}$, and an output current of this buffer circuit can be set in under $\phi_{BE}$.

Reference signs in the claims are intended for better understanding and shall not limit the scope.

## Claims

1. An output buffer circuit characterized by comprising:
an input node (1);
an output node (2);
a positive power source ($V_{DD}$);
a logic circuit (10) connected to said input node (1);
means (11) connected at one end to said logic circuit (10), for dropping a voltage of said positive power source ($V_{DD}$); and
an npn bipolar transistor (12) having a base connected to the other end of said voltage dropping means (11), a collector connected to said output node (2) and an emitter connected to a circuit ground (GND).

2. An output buffer circuit according to claim 1, characterized in that said logic circuit means (10) connects said dropping means (11) to said positive power source ($V_{DD}$) when receiving a first potential from said input node (1) and connects the base of said bipolar transistor (12) to said circuit ground (GND) when receiving a second potential.

3. An output buffer circuit according to claim 2, characterized in that said logic circuit (10) includes a p-type FET (20) having a first gate connected to said input node (1), a first source connected to said positive power source ($V_{DD}$) and a first drain connected to one end of said dropping means (11) and an n-type FET (21) having a second gate connected to said input node (1), a second drain connected to the base of said bipolar transistor (12) and a second source connected to said circuit ground (GND); and said dropping means includes a resistor (22).

4. An output buffer circuit according to claim 3, characterized in that said collector of said bipolar transistor (12) is connected to said positive power source ($V_{DD}$) via a resistor (24).

5. An output buffer circuit according to claim 1, characterized in that said logic circuit (10) includes an n-type FET (21) having a first gate connected to said input node (1), a first drain connected to the base of said bipolar transistor (12) and to one end of said dropping means (11) and a first source connected to said circuit ground (GND); and said dropping means (11) includes a resistor (25) connected to said positive power source ($V_{DD}$).

6. An output buffer circuit according to claim 5, characterized in that said collector of said bipolar transistor (12) is connected to said positive power source ($V_{DD}$) via a resistor (24).

7. An output buffer circuit according to claim 2, characterized in that said logic circuit (10) includes a p-type FET (20) having a first gate connected to said input node (1), a first source connected to said positive power source ($V_{DD}$) and a first drain connected to one end of said dropping means (11) and an n-type FET (21) having a second gate connected to said input node (1), a second drain connected to the base of said bipolar transistor (12) and a second source connected to said circuit ground (GND); and said dropping means (11) includes first and second resistors (32 and 33); and characterized by further comprising a diode (34) connected at one end to a connection node between said first and second resistors (32 and 33) and connected at the other end to the collector of said bipolar transistor (12).

8. An output buffer circuit according to claim 7, characterized in that said diode (34) is a Schottky diode.

9. An output buffer circuit according to claim 7, characterized by further comprising a second bipolar transistor (38) having a base connected to said input node (1); a collector connected to said positive power source ($V_{DD}$); and an emitter connected to said output node (2).

Vdd

10

LOGIC CIRCUIT

DROPPING VOLTAGE MEANS

11

12

2

FIG. 1

20

1

VC

22

R₁

VA

21

12

VOL

2

FIG. 2

FIG. 3

FIG. 4

FIG. 5

FIG. 6

FIG. 7

FIG. 8

FIG. 9

FIG. 10

CURRENT CHARACTERISTIC
OF PRIOR-ART CIRCUIT

CURRENT CHARACTERISTIC
OF THIS INVENTION

F I G.   11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 172 350 (FUJITSU LIMITED) * figure 1; abstract * | 1-3 | H 03 K 19/0175 H 03 K 19/08 |
| A | PATENT ABSTRACTS OF JAPAN vol. 11, no. 209 (E-521)(2656), 7 July 1987; & JP-A-6231217 (HITACHI LTD.) 10.02.1987 | 1,5,6 | |
| A | US-A-4 065 683 (G. CLARKE) * figure 1; column 2, line 46 - column 3, line 2 * | 1 | |
| A | IBM TECHNICAL DISCLOSURE BULLETIN vol. 26, no. 9, February 1984, page 4655, New York, US; A.F. FAVATA et al.: "Multi-Drive (Non-Inverting) Open Collector Driver" * whole document * | 1 | |
| A | IBM TECHNICAL DISCLOSURE BULLETIN vol. 26, no. 9, February 1984, page 4512, New York, US; A.F. FAVATA et al.: "Open Collector Driver Circuit" * whole document * | 1 | TECHNICAL FIELDS SEARCHED (Int. Cl.5) |
| A | IBM TECHNICAL DISCLOSURE BULLETIN vol. 26, no. 7B, December 1983, page 3973, New York, US; A.F. FAVATA et al.: "Multi-Drive (Inverting) Open Collector Driver" * whole document * | 1 | H 03 K 5/02 H 03 K 19/0175 H 03 K 19/018 H 03 K 19/08 H 03 K 19/082 H 03 K 19/088 |
| A | EP-A-0 145 004 (HITACHI LTD.) | | |

The present search report has been drawn up for all claims

| Place of search | Date of completion of the search | Examiner |
|---|---|---|
| BERLIN | 15-06-1990 | ARENDT M |